# DEMANDE DE BREVET EUROPEEN

(11) **EP 4 576 134 A1**
(43) Date de publication de la demande: **25.06.2025**
(21) Numéro de dépôt: 24222198.4
(22) Date de dépôt: 20.12.2024
(51) Int. Cl.: H01F 27/02, H01F 27/22, H01F 27/26

(54) **DISPOSITIF DE COUPLAGE THERMIQUE POUR UNE INDUCTANCE DE MODE COMMUN**

(30) Priorité: 22.12.2023 FR 2314970
(71) Demandeur: Valeo eAutomotive Germany GmbH, 91056 Erlangen (DE)
(72) Inventeur: RICHE, Christopher, 94046 CRETEIL CEDEX (FR); FALGUIER, Manuel, 94046 CRETEIL CEDEX (FR); POUILY, Aurélien, 95892 Cergy Pontoise (FR)
(74) Mandataire: Valeo Powertrain Systems

(57) **Abrégé**

La présente invention vise un dispositif de couplage thermique (2) pour une inductance de mode commun, configuré pour transférer de la chaleur vers un dissipateur thermique (5), le dispositif comprenant :
- un noyau (4) de ferrite prismatique annulaire configuré pour être traversé par au moins un connecteur électrique d'un composant électronique (3) ;
- un socle (6) solidaire du dissipateur thermique (5), le noyau (4) de ferrite étant en contact avec le socle (6), le socle étant configuré pour transférer de la chaleur générée par le noyau de ferrite (4) vers le dissipateur thermique (5).

Le dispositif de couplage thermique (2) comprend un organe de serrage (8) configuré pour maintenir solidaire le noyau (4) de ferrite et le socle (6), le noyau (4) de ferrite, le socle (6) et l'organe de serrage (8) s'étendant orthogonalement au plan de référence longitudinal du connecteur électrique.

## Description

### DOMAINE TECHNIQUE

La présente invention concerne le domaine technique des véhicules électriques ou hybrides.

Plus précisément, l'invention concerne le domaine technique des convertisseurs de tension et le refroidissement de composants électroniques formant de tels convertisseurs de tension.

### ETAT DE LA TECHNIQUE

Il est connu de l'état de la technique véhicule électrique ou hybride comprenant un convertisseur de tension, notamment un onduleur, configuré pour convertir une tension de courant continu provenant d'une batterie haute tension en une tension de courant alternatif afin d'alimenter en tension alternative un moteur électrique. Pour assurer le fonctionnement d'un tel convertisseur de tension au sein d'un environnement électromagnétique sans générer de perturbations électromagnétiques pouvant affecter d'autres systèmes électriques dudit véhicule, le convertisseur de tension comprend notamment un filtre de compatibilité électromagnétique, couramment désigné « filtre CEM » par l'homme du métier.

Pour remplir cette fonction de filtrage, le filtre CEM comprend une pluralité de capacité. Ces capacités, lors du filtrage, dissipent de l'énergie sous forme d'énergie thermique. Il est alors connu d'associer à ces capacités des inductances, couramment désignées par l'homme du métier « inductances de modes communs », permettant de limiter l'échauffement des capacités du filtre CEM. Néanmoins, les inductances de mode commun nécessitent elles-mêmes d'être refroidies, en particulier l'inductance de mode commun en sortie du dispositif de filtrage, c'est-à-dire reliée notamment à une capacité de liaison.

L'invention vise à remédier à tout inconvénient de l'état de la technique, en proposant notamment un dispositif de couplage thermique configuré pour refroidir une inductance de mode commun.

### PRESENTATION DE L'INVENTION

Plus précisément, l'invention a pour objet un dispositif de couplage thermique pour une inductance de mode commun, configuré pour transférer de la chaleur vers un dissipateur thermique, le dispositif comprenant :
- un noyau de ferrite prismatique annulaire configuré pour être traversé par au moins un connecteur électrique du composant électronique s'étendant au moins partiellement selon un plan de référence longitudinal, le noyau de ferrite étant configuré pour générer un champ magnétique induit par un courant électrique circulant dans le connecteur électrique du composant électronique ;
- un socle solidaire du dissipateur thermique, le noyau de ferrite étant en contact avec le socle, le socle étant configuré pour transférer de la chaleur générée par le noyau de ferrite vers le dissipateur thermique.

Le dispositif de couplage thermique est remarquable en ce qu'il comprend un organe de serrage configuré pour maintenir solidaire le noyau de ferrite et le socle, le noyau de ferrite, le socle et l'organe de serrage s'étendant orthogonalement au plan de référence longitudinal du connecteur électrique. Grâce à une telle combinaison de caractéristique, le dispositif de couplage thermique permet un transfert efficace de la chaleur générée par le noyau de ferrite vers le dissipateur thermique, par l'intermédiaire du socle. Dans une telle configuration, le refroidissement de l'inductance de mode commun est alors optimisé.

Avantageusement, le socle et l'organe de serrage présentent une structure prismatique annulaire et sont coaxiaux avec le noyau de ferrite, le socle et l'organe de serrage étant en outre configurés pour être traversés par le connecteur électrique. Dans une telle configuration, la tenue mécanique du dispositif de couplage mécanique est améliorée, le noyau de ferrite, le socle et l'organe de serrage présentant une structure géométrique similaire. Par ailleurs. En outre, la compacité d'un tel dispositif est améliorée, l'intégralité des composants du dispositif de couplage étant traversés par le connecteur électrique.

Avantageusement, le socle comprend une base sensiblement plane s'étendant parallèlement au plan de référence, ladite base du socle étant en contact surfacique avec le dissipateur thermique. Dans une telle configuration, le transfert thermique de chaleur vers le dissipateur thermique est amélioré, ainsi que la fixation du socle par rapport au dissipateur thermique.

Avantageusement, le dispositif de couplage comprend un matériau de remplissage thermo-conducteur, ledit matériau étant intercalé entre la base et le dissipateur thermique. Un tel matériau permet d'optimiser le drainage des calories vers le dissipateur thermique.

Avantageusement, l'organe de serrage est formé par une lame ressort solidaire de la base du socle. Dans une telle configuration, le maintien en position du noyau de ferrite par rapport au socle est amélioré.

Avantageusement, le noyau de ferrite est monobloc. Dans une telle configuration, la tenue mécanique du dispositif de couplage est encore améliorée.

Avantageusement, une rainure annulaire est ménagée dans le socle, le noyau de ferrite étant logé dans la rainure du socle. Dans une telle configuration, la surface de contact d'échange thermique entre le noyau de ferrite et le socle est sensiblement augmenté, améliorant le refroidissement du noyau de ferrite.

Avantageusement, le dispositif de couplage thermique comprend un matériau de remplissage thermo-conducteur, ledit matériau étant intercalé entre le socle et le noyau de ferrite. Un tel matériau permet d'optimiser le drainage des calories vers le socle.

Selon un autre aspect de l'invention, celle-ci a trait à un équipement électrique comprenant :
- au moins un composant électronique ;
- un dissipateur thermique ;
- au moins un dispositif de couplage thermique tel que décrit ci-dessus.

Selon un autre aspect de l'invention, celle-ci a trait à un procédé d'assemblage d'un équipement électrique tel que décrit ci-dessus, comprenant :
- la fixation du socle du dispositif de couplage thermique au dissipateur thermique orthogonalement à un plan de référence longitudinal ;
- la mise en position du noyau de ferrite du dispositif de couplage thermique au contact du socle ;
- le maintien en position du noyau de ferrite au contact du socle par l'intermédiaire de l'organe de serrage du dispositif de couplage thermique ;
- le passage du connecteur électrique du composant électronique à travers un orifice débouchant du noyau de ferrite de sorte que le connecteur électrique s'étende au moins partiellement dans le plan de référence longitudinal.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
la figure 1 est une représentation schématique en perspective isométrique d'un équipement électrique selon un premier aspect de l'invention ;
la figure 2 est une représentation schématique en perspective isométrique d'un dispositif de couplage selon un autre aspect de l'invention ;
la figure 3 est une représentation schématique en vue de dessus d'un détail de l'équipement électrique de la figure 1.

Il faut noter que les figures exposent l'invention de manière détaillée pour permettre de mettre en oeuvre l'invention ; bien que non limitatives, lesdites figures servent notamment à mieux définir l'invention le cas échéant.

### DESCRIPTION DETAILLEE DE L'INVENTION

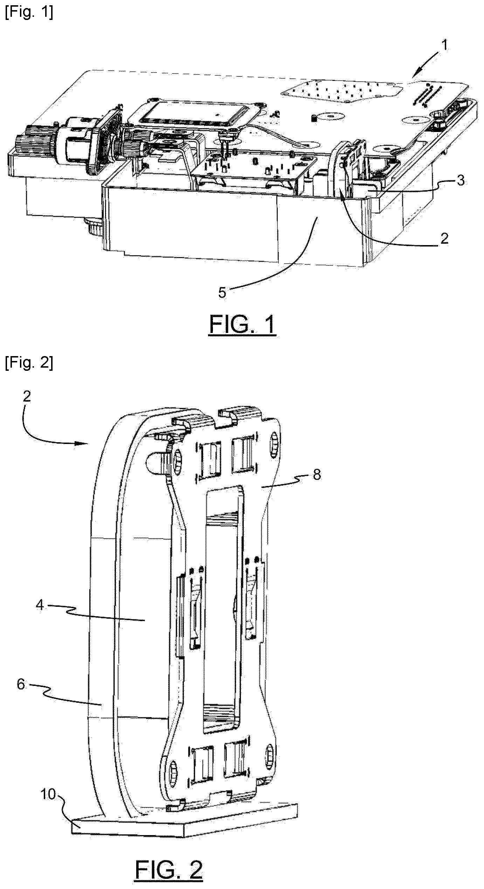

L'invention concerne notamment un équipement électrique 1 tel qu'un convertisseur de tension, par exemple un onduleur. L'équipement électrique 1 comprend un corps délimitant un logement et un couvercle. Sur la figure 1, l'équipement électrique 1 est illustré dans une configuration retirée du couvercle.

L'équipement électrique 1 comprend notamment au moins un composant électronique 3 disposé dans le logement devant être refroidi pour s'assurer de son fonctionnement. Le composant électronique 3 peut notamment être une capacité, en particulier une capacité d'un filtre CEM. Le composant électronique 3 comprend au moins un connecteur électrique s'étendant au moins partiellement selon un plan de référence longitudinal. Pour être refroidi, la chaleur générée par le composant électronique 3 est transmise à un dissipateur thermique 5 de l'équipement électrique 1. Ici, le dissipateur thermique 5 est formé par le corps de l'équipement électrique 1.

L'équipement électrique 1 comprend un dispositif de couplage thermique 2 configuré pour transférer de la chaleur. Le dispositif de couplage thermique 2 est illustré sur la figure 2. Le dispositif de couplage thermique 2 comprend un noyau de ferrite 4. Le noyau de ferrite 4 est prismatique et annulaire, et est configuré pour être traversé par au moins un connecteur électrique du composant électronique 3, de préférence par deux connecteurs électriques, cette configuration étant désignée « mode commun » par l'homme du métier. Autrement dit, un orifice débouchant est ménagé dans le noyau de ferrite 4, le connecteur électrique traversant l'orifice débouchant. Le noyau de ferrite 4 est configuré pour générer un champ magnétique induit par les courants électriques circulant dans les connecteurs électriques du composant électronique 3 le traversant, générant par la même occasion de la chaleur par effet Joule.

Par ailleurs, le dispositif de couplage thermique 2 comprend un socle 6 solidaire du dissipateur thermique 5, le noyau de ferrite 4 étant en contact avec le socle 6. Le socle 6 est configuré pour transmettre par conduction la chaleur générée par le noyau de ferrite 4 au dissipateur thermique 5. Pour maintenir en position le noyau de ferrite 4 sur le socle 6, le dispositif de couplage thermique 2 comprend en outre un organe de serrage 8. Ainsi, le socle 6, le noyau de ferrite 4 et l'organe de serrage 8 s'étendent orthogonalement au plan de référence longitudinal du connecteur électrique du composant électronique 3. Grâce à une telle combinaison de caractéristique, le dispositif de couplage thermique 2 permet un transfert efficace de la chaleur générée par le noyau de ferrite 4 vers le dissipateur thermique 5, par l'intermédiaire du socle 6. Dans une telle configuration, le refroidissement du noyau 4 est maximisé. Du fait de sa canalisation de la chaleur générée par d'autres composants du l'équipement électrique 1, le noyau de ferrite 4 est alors désigné « victime core ». Un tel organe de serrage 8 permet de plaquer efficacement le noyau de ferrite 4 sur le socle 6, permettant de maximiser la conduction thermique et garantissant une tenue mécanique de l'ensemble du dispositif de couplage thermique 2. Enfin, la disposition « debout » du dispositif de couplage thermique 2 permet de répondre à des contraintes différentes d'encombrement, notamment différentes d'une configuration « couchée » du noyau de ferrite 4. Avantageusement, le dispositif de couplage thermique comprend un matériau de remplissage thermo-conducteur, ledit matériau étant intercalé entre la base 10 et le dissipateur thermique 5. Un tel matériau intercalé de la sorte permet d'optimiser le drainage des calories vers le dissipateur thermique 5.

Dans le mode de réalisation décrit sur la figure 2, le socle 6 et l'organe de serrage 8 présentent une structure prismatique annulaire et sont coaxiaux avec le noyau de ferrite 4. Ainsi, le socle 6 et l'organe de serrage 8 sont également configurés pour être traversés par le connecteur électrique du composant électronique 3. En plus de permettre une meilleure tenue mécanique du dispositif de couplage thermique 2, cette configuration permet également de maximiser la surface d'échange de conduction thermique entre le noyau de ferrite 4 et le socle 6. Par ailleurs, la compacité du dispositif est améliorée.

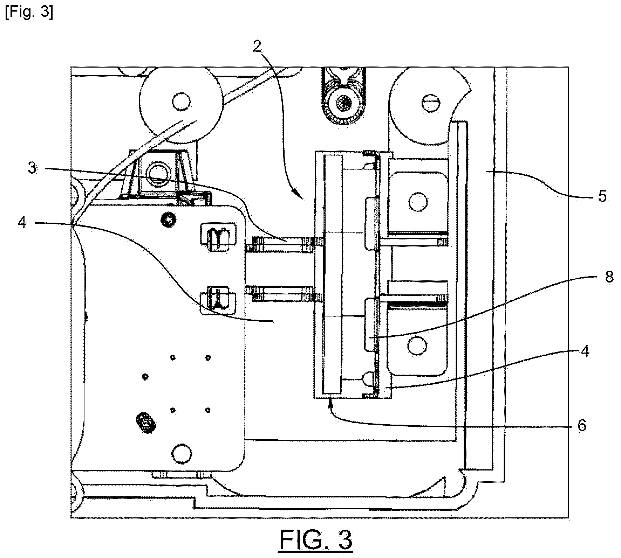

Le socle 4 comprend de préférence une base 10. La base 10, substantiellement plane, s'étend parallèlement au plan de référence longitudinal, comme illustré sur la figure 3. La base 10 permet un contact surfacique avec le dissipateur thermique 5. Le transfert thermique de chaleur vers le dissipateur thermique 5 est amélioré. La fixation du socle 6, verticalement par rapport au dissipateur thermique 5 est également améliorée avec une telle base 10. Avantageusement, le dispositif de couplage thermique 2 un matériau de remplissage thermo-conducteur, ledit matériau étant intercalé entre le socle (6) et le noyau de ferrite 4. Un tel matériau intercalé de la sorte permet d'optimiser le drainage des calories vers le socle 6.

De préférence encore, l'organe de serrage 8 est formé par une lame ressort, solidaire de la base 10 et du socle 6. Le maintien en position du noyau de ferrite par rapport au socle est amélioré. La lame ressort présente l'avantage d'exercer une pression sensiblement uniforme sur le noyau de ferrite 4, en adapté à la dureté et à la faible déformabilité élastique de la ferrite par rapport aux autres composants de l'équipement électrique 1.

Le socle 6 peut comprendre une rainure ménagée dans ledit socle 6. Dans une telle configuration, le noyau de ferrite 4 est logé dans la rainure du socle. La surface de contact d'échange thermique entre le noyau de ferrite 4 et le socle 6 est alors encore augmentée, améliorant encore davantage le refroidissement de la ferrite. Pour monter le dispositif de couplage thermique 2 dans le logement de l'équipement électrique 1, le socle 6 est dans un premier temps fixé au dissipateur thermique 5, orthogonalement à un plan de référence longitudinal. Le noyau de ferrite 4 est monté au contact du socle 6, puis le noyau de ferrite 4 est maintenu contre le socle 6 par le serrage de l'organe de serrage 8 sur le socle 6. Le connecteur électrique du composant électronique 3 est alors passé à travers l'orifice débouchant du noyau de ferrite 4, puis raccordé à d'autres composants de l'équipement électrique 1, par exemple une capacité de liaison.

On notera par ailleurs que l'invention n'est pas limitée aux modes de réalisation décrit précédemment. Il apparaîtra en effet à l'homme du métier que diverses modifications peuvent être apportées au mode de réalisation décrit ci-dessus, à la lumière de l'enseignement qui vient de lui être divulgué.

Dans la présentation détaillée de l'invention qui est faite précédemment, les termes utilisés ne doivent pas être interprétés comme limitant l'invention au mode de réalisation exposé dans la présente description, mais doivent être interprétés pour y inclure tous les équivalents dont la prévision est à la portée de l'homme du métier en appliquant ses connaissances générales à la mise en oeuvre de l'enseignement qui vient de lui être divulgué.

## Revendications

1. Dispositif de couplage thermique (2) pour une inductance de mode commun, configuré pour transférer de la chaleur vers un dissipateur thermique (5), le dispositif comprenant :
- un noyau (4) de ferrite prismatique annulaire configuré pour être traversé par au moins un connecteur électrique du composant électronique (3) s'étendant au moins partiellement selon un plan de référence longitudinal, le noyau (4) de ferrite étant configuré pour générer un champ magnétique induit par un courant électrique circulant dans le connecteur électrique du composant électronique 3 ;
- un socle (6) solidaire du dissipateur thermique (5), le noyau (4) de ferrite étant en contact avec le socle (6), le socle étant configuré pour transférer de la chaleur générée par le noyau de ferrite (4) vers le dissipateur thermique (5) ;
le dispositif de couplage thermique (2) étant **caractérisé en ce qu'**il comprend un organe de serrage (8) configuré pour maintenir solidaire le noyau (4) de ferrite et le socle (6), le noyau (4) de ferrite, le socle (6) et l'organe de serrage (8) s'étendant orthogonalement au plan de référence longitudinal du connecteur électrique.

2. Dispositif de couplage thermique (2) selon la revendication 1, dans lequel le socle (6) et l'organe de serrage (8) présentent une structure prismatique annulaire et sont coaxiaux avec le noyau (4) de ferrite, le socle (6) et l'organe de serrage (8) étant en outre configurés pour être traversés par le connecteur électrique.

3. Dispositif de couplage thermique (2) selon l'une quelconque des revendications précédentes, dans lequel le socle (6) comprend une base (10) sensiblement plane s'étendant parallèlement au plan de référence, ladite base (10) du socle (6) étant en contact surfacique avec le dissipateur thermique (5).

4. Dispositif de couplage thermique (2) selon la revendication 3, comprenant un matériau de remplissage thermo-conducteur, ledit matériau étant intercalé entre la base (10) et le dissipateur thermique (5).

5. Dispositif de couplage thermique (2) selon l'une des revendications 3 à 4, dans lequel l'organe de serrage (8) est formé par une lame ressort solidaire de la base (10) du socle (6).

6. Dispositif de couplage thermique (2) selon l'une quelconque des revendications précédentes, dans lequel le noyau (4) de ferrite est monobloc.

7. Dispositif de couplage thermique (2) selon l'une quelconque des revendications précédentes, dans lequel une rainure annulaire est ménagée dans le socle (6), le noyau (4) de ferrite étant logé dans la rainure du socle (6).

8. Dispositif de couplage thermique (2) selon l'une quelconque des revendications précédentes, comprenant un matériau de remplissage thermo-conducteur, ledit matériau étant intercalé entre le socle (6) et le noyau de ferrite (4).

9. Equipement électrique (1) comprenant :
- au moins un composant électronique (3) ;
- un dissipateur thermique (5) ;
- au moins un dispositif de couplage thermique (2) selon l'une quelconque des revendications 1 à 6.

10. Procédé d'assemblage d'un équipement électrique (1) selon la revendication 7, comprenant :
- la fixation du socle (6) du dispositif de couplage thermique (2) au dissipateur thermique (5) orthogonalement à un plan de référence longitudinal ;
- la mise en position du noyau (4) de ferrite du dispositif de couplage thermique (2) au contact du socle (6) ;
- le maintien en position du noyau (4) de ferrite au contact du socle (6) par l'intermédiaire de l'organe de serrage (8) du dispositif de couplage thermique (2) ;
- le passage du connecteur électrique du composant électronique (3) à travers un orifice débouchant du noyau (4) de ferrite de sorte que le connecteur électrique s'étende au moins partiellement dans le plan de référence longitudinal.
